Europäisches Patentamt

European Patent Office

Office européen des brevets

(19)

(11) Veröffentlichungsnummer: **0 011 160**
**A1**

(12) # EUROPÄISCHE PATENTANMELDUNG

(21) Anmeldenummer: **79104118.9**

(22) Anmeldetag: **24.10.79**

(51) Int. Cl.³: **C 21 D 1/773**
**C 21 D 1/38, C 23 C 11/14**
**F 27 B 9/04**

(30) Priorität: **15.11.78 DE 2849514**

(43) Veröffentlichungstag der Anmeldung:
**28.05.80 Patentblatt 80/11**

(84) Benannte Vertragsstaaten:
**FR GB IT**

(71) Anmelder: **Klöckner Ionon GmbH**
**Mainzer Strasse 71**
**D-5000 Köln 1(DE)**

(72) Erfinder: **Herter, Martin, Dipl.-Ing.**
**Am Driesch 19**
**D-5021 Geyen(DE)**

(74) Vertreter: **Gross, Reinhold, Dr.**
**Rembrandtstrasse 19**
**D-5628 Heiligenhaus(DE)**

(54) **Verbindungsstück für Vakuumbehälter zum Wärmebehandeln von Werkstücken.**

(57) Ein Verbindungsstück für Vakuumbehälter zum Wärmebehandeln von Werkstücken, wobei insbesondere mindestens ein Vakuumbehälter zum Behandeln von Werkstücken mit Hilfe von Gasentladungen geeignet ist, benutzt ein mit Durchtrittsöffnungen versehenes Gehäuse, in dem ein in vakuumdichter Schließstellung bewegliches Absperrorgan angeordnet ist, sowie Anschlußstücke zum Anschließen von Behältern.

Zur Vermeidung von Verzugsproblemen und von aufwendiger Bearbeitung besteht das Verbindungsstück aus einem zylinderförmigen Gehäuse (11) und einem darin befindlichen, sich gegenüber diesem drehbaren Absperrorgan (12), das aus einem teilzylindrischen Absperrschild (14) besteht, das sich über mindestens etwa ein Viertel des Zylinderumfanges des Gehäuses (11) erstreckt. Ein derartiges Verbindungsstück kann auch selbst als Behandlungsraum dienen, wenn der Absperrschild (14) groß genug ist, um sämtliche Durchtrittsöffnungen zu verschließen.

Fig.1

EP 0 011 160 A1

- 1 -

## Verbindungsstück für Vakuumbehälter zum Wärmebehandeln von Werkstücken

Die Erfindung betrifft ein Verbindungsstück für Vakuumbehälter zum Wärmebehandeln von Werkstücken, wobei insbesondere mindestens ein Vakuumbehälter zum Behandeln von Werkstücken mit Hilfe von Gasentladungen geeignet ist, mit einem mit Durchtrittsöffnungen versehenen Gehäuse, in dem ein in vakuumdichter Schließstellung bewegliches Absperrorgan angeordnet ist, und Anschlußstücken zum Anschließen von Behältern.

Zur Verbindung von Vakuumbehältern werden derzeit plattenförmige Absperrorgane, sogenannte Messerschieber verwendet, die aus einem Rahmen bestehen, der eine umlaufende Dichtung aufweist, und in dem eine Platte einschiebbar ist. Die Platte muß hierbei in die gesamte Dichtung hineingefahren werden, wodurch sich ein großer Verschleiß ergibt. Außerdem ergeben sich bei einer derartigen Platte insbesondere bei einseitiger Druck- und/oder Temperaturbelastung Verzugs- und Dichtungsprobleme. Die Platten erfordern ferner eine große Einbauhöhe für ihre Bewegung und zudem aufwendige Schleifarbeiten an den Dichtkanten, wobei die gesamte Kraft bei einseitiger Druck- und/oder Temperaturbelastung auf den Rahmen und damit auf die Dichtflächen wirkt.

Aufgabe der Erfindung ist es, ein Verbindungsstück der eingangs genannten Art zu schaffen, bei dem praktisch keine Verzugsprobleme auftreten und das keine aufwendige Bearbeitung benötigt.

Diese Aufgabe wird dadurch gelöst, daß das Verbindungsstück aus einem zylinderförmigen Gehäuse und einem darin befindlichen, sich gegenüber diesem drehbaren Absperrorgan besteht, wobei das Absperrorgan aus einem teilzylinderischen Absperrschild besteht, das sich über mindestens etwa ein Viertel des Zylinderumfanges des Gehäuses erstreckt.

Die gekrümmte Fläche des erfindungsgemäß verwendeten Absperrschildes widersteht Druck- und/oder Temperaturbelastungen wesentlich besser als eine Platte, weshalb auch ein weniger starkes Blech Verwendung finden kann. Kräfte werden hierbei nur von den Lagerstellen abgefangen, sie beeinflussen die Dichtflächen nicht.

Abgesehen davon kann ein derartiges Verbindungsstück selbst als Behandlungsraum verwendet werden, wenn der Absperrschild groß genug ist, um sämtliche Durchtrittsöffnungen zu verschließen.

Das erfindungsgemäße Verbindungsstück eignet sich insbesondere zum Verbinden von Vakuumbehältern, die zum Behandeln von Werkstücken mit Hilfe von Glimmentladung etwa zum Nitrierhärten verwendet werden, bzw. zur zusätzlichen Verwendung von weiteren Behandlungsbehältern etwa zum Abkühlen nach der Glimmentladungsbehandlung oder zum Abschrecken. So kann beispielsweise in einem ersten Behälter ein Aufheizen der Werkstücke auf Behandlungstemperatur erfolgen, wonach ein Überführen der Werkstücke in ein Verbindungsstück erfolgt, wo die eigentliche Glimmentladungsbehandlung vorgenommen wird. Danach können die Werkstücke in einen weiteren Behälter überführt werden, in dem eine Abkühlung der Werkstücke erfolgt.

Das Absperrorgan kann zwei Lagerscheiben benachbart den Stirnwänden des zylinderförmigen Gehäuses umfassen, die durch den Absperrschild miteinander verbunden sind.

Das Absperrorgan kann ferner beidseitig der Durchtrittsöffnungen Ringflansche benachbart den Stirrwänden des zylinderförmigen Gehäuses aufweisen, die sich in Axialrichtung des Gehäuses erstrecken. Hierbei können die Lagerscheiben dicht mit den Ringflanschen verbunden sein, während die Lagerscheiben durch sternförmig angeordnete Stege verstärkt sein können.

An einer zu verschließenden Durchtrittsöffnung beidseitig in Drehrichtung des Absperrorgans kann jeweils eine sich in Richtung der Längsachse des zylinderförmigen Gehäuses erstreckende Liniendichtung und ebenfalls beidseitig der Durchtrittsöffnung in Radialrichtung des Gehäuses jeweils eine Radialdichtung für das Absperrorgan vorgesehen sein, wobei die Dichtungen zweckmäßigerweise durch T-Stücke miteinander verbunden sind. Vorteilhaft ist das zylinderförmige Gehäuse im Bereich der Dichtungen wassergekühlt.

Das Absperrorgan kann mit hohlen oder massiven Achsstummeln verbunden sein, die in dem zylinderförmigen Gehäuse gelagert sind. Das Absperrorgan kann ferner mit Hilfe von Lagerbuchsen auf Achsstummeln drehbar gelagert sein. Das Absperrorgan kann hierbei durch Drehen eines Achsstummels drehbar sein. Die Stege können mit den Achsstummeln bzw. den Lagerbuchsen und den Ringflanschen verbunden sein.

Das Absperrorgan kann vorteilhaft Transportschienen aufweisen, die sich in den Anschlußstücken fortsetzen.

In dem Verbindungsstück kann eine Transporteinrichtung vorgesehen sein, wobei das zu behandelnde Gut in dem Verbindungsstück insbesondere durch die Transporteinrichtung drehbar und/oder anhebbar sein kann. Die Transporteinrichtung kann ein Kettenförderer sein, der eine oder zwei Zahnketten aufweist. Der Kettenförderer kann durch eine Hohlwelle hindurch antreibbar sein, die von außerhalb des Verbindungsstücks heb- und senkbar ist, wodurch der Kettenförderer insgesamt heb- und senkbar ist. In dem Verbindungsstück kann eine Wendeeinrichtung vorgesehen sein. Die anzuschließenden Vakuumbehälter können mit einer entsprechenden Transporteinrichtung ausgerüstet sein.

Die Erfindung wird nachfolgend anhand der in den beigefügten Abbildungen dargestellten Ausführungsbeispiele näher erläutert.

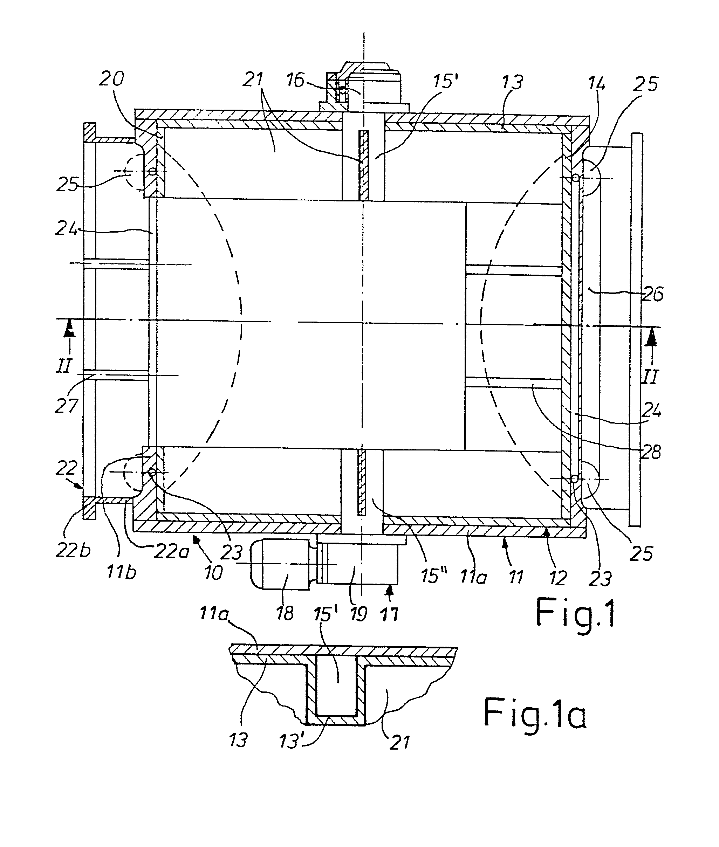

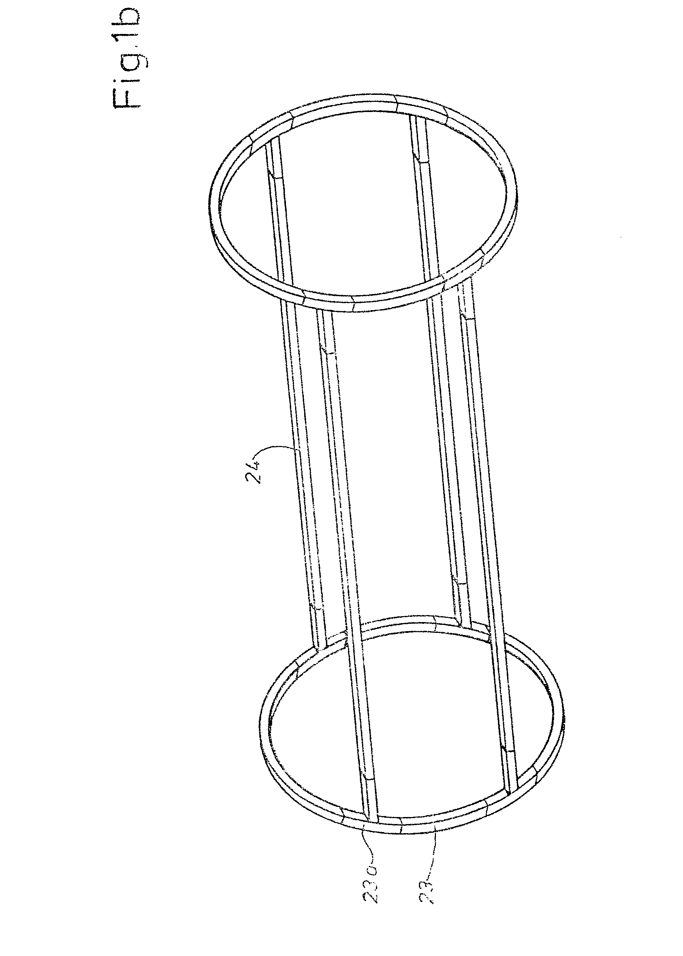

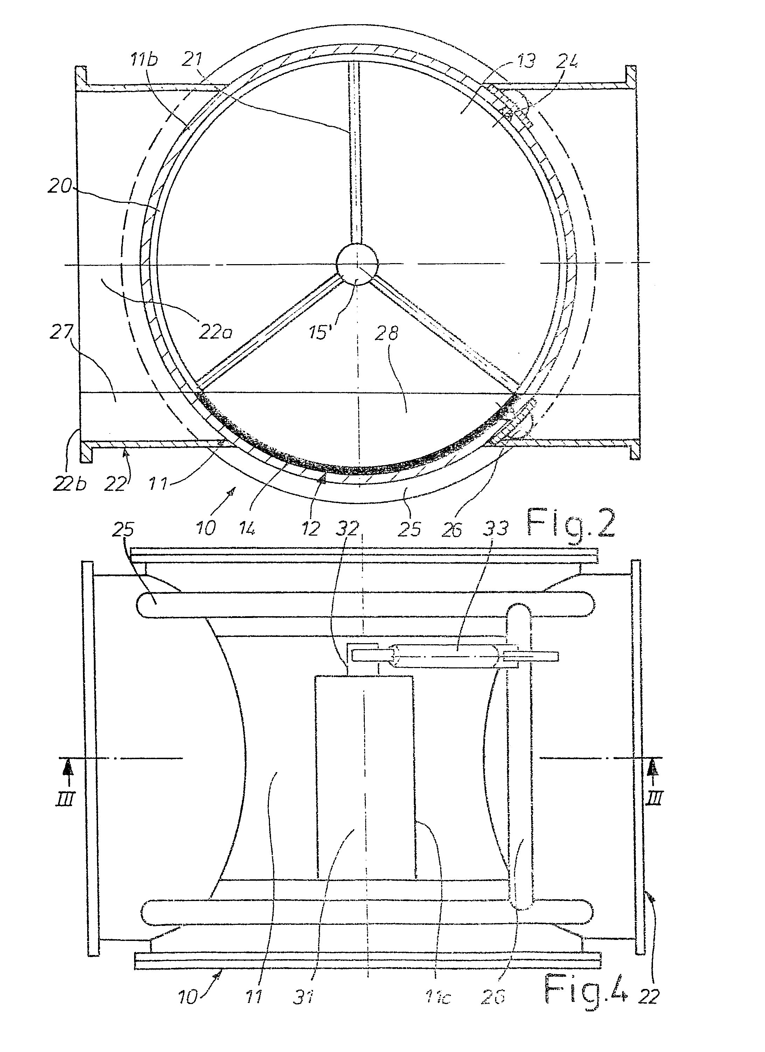

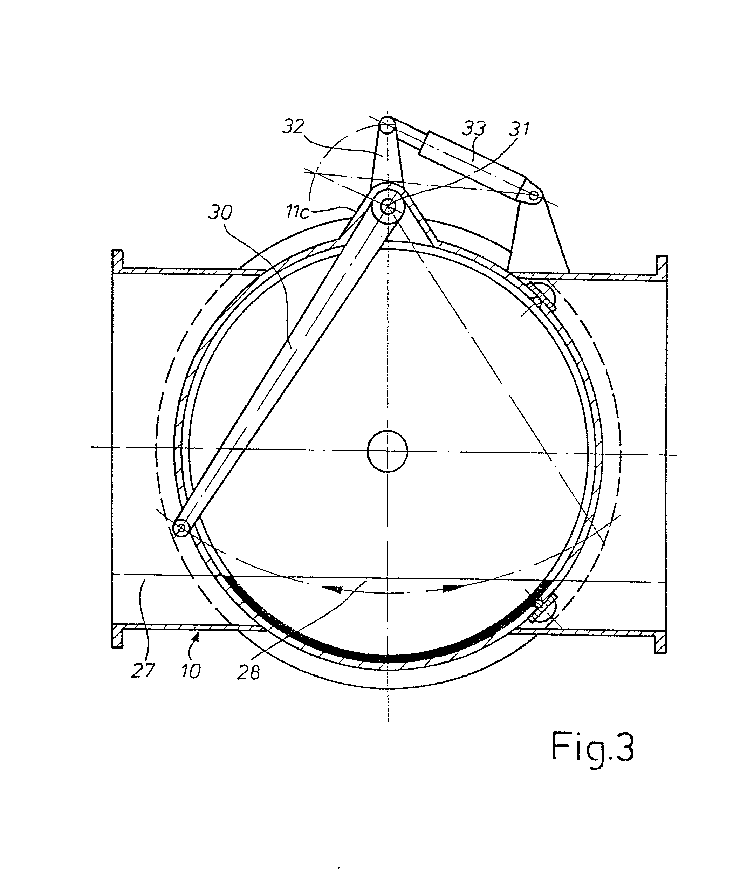

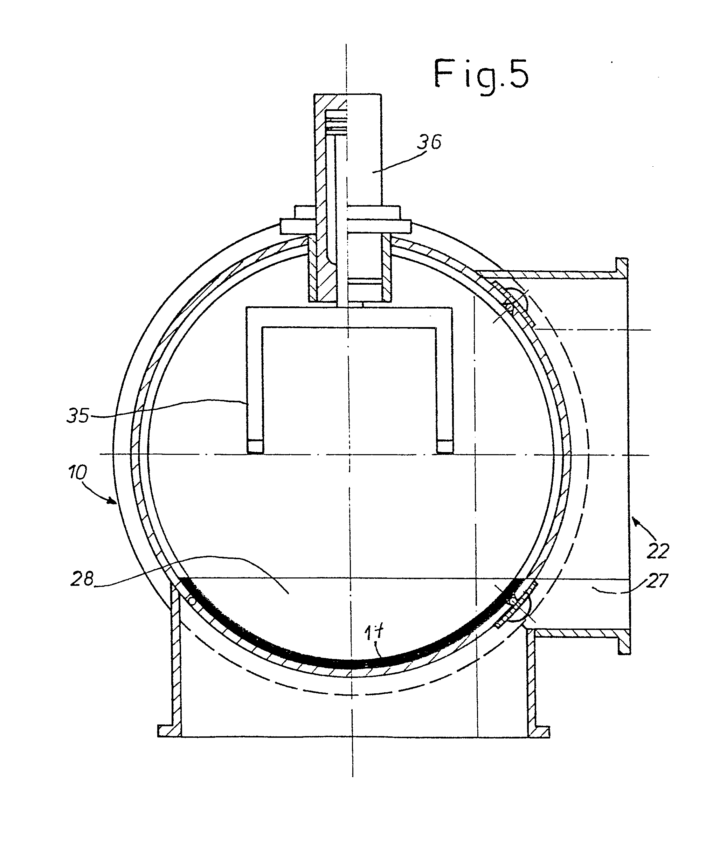

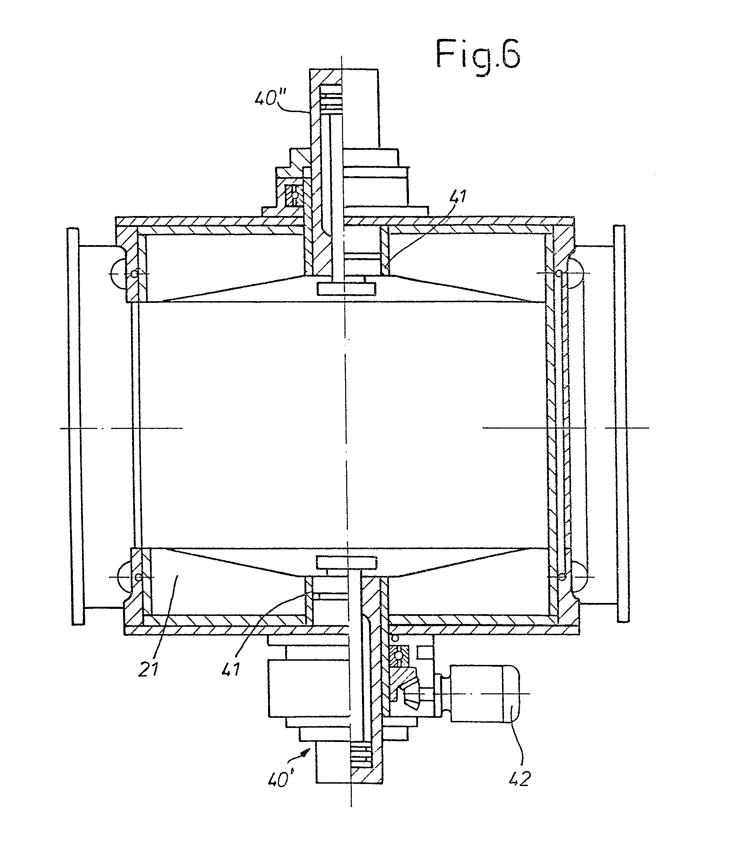

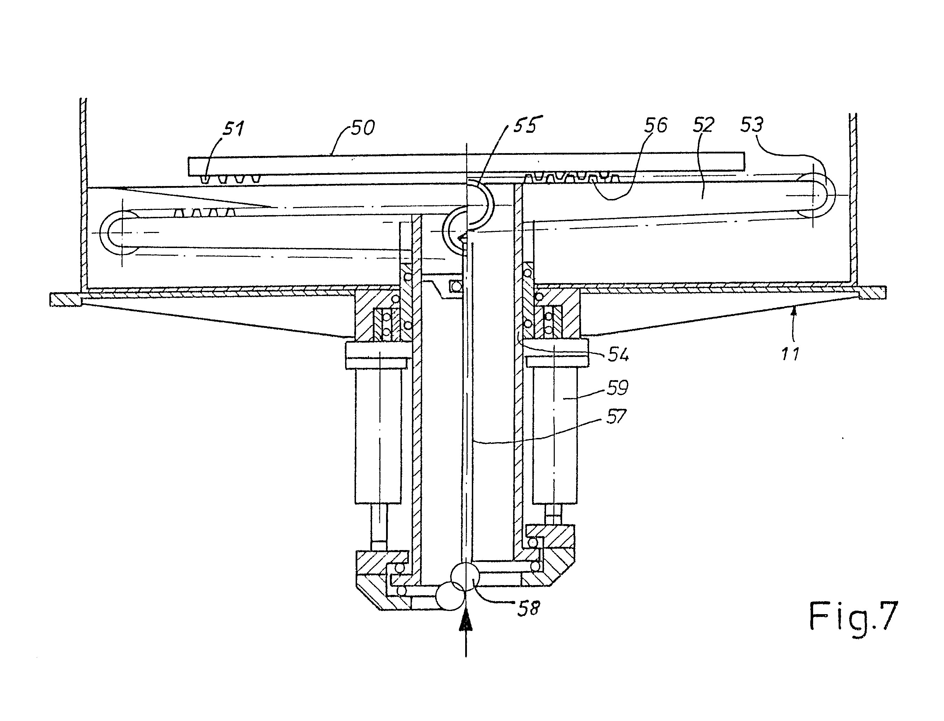

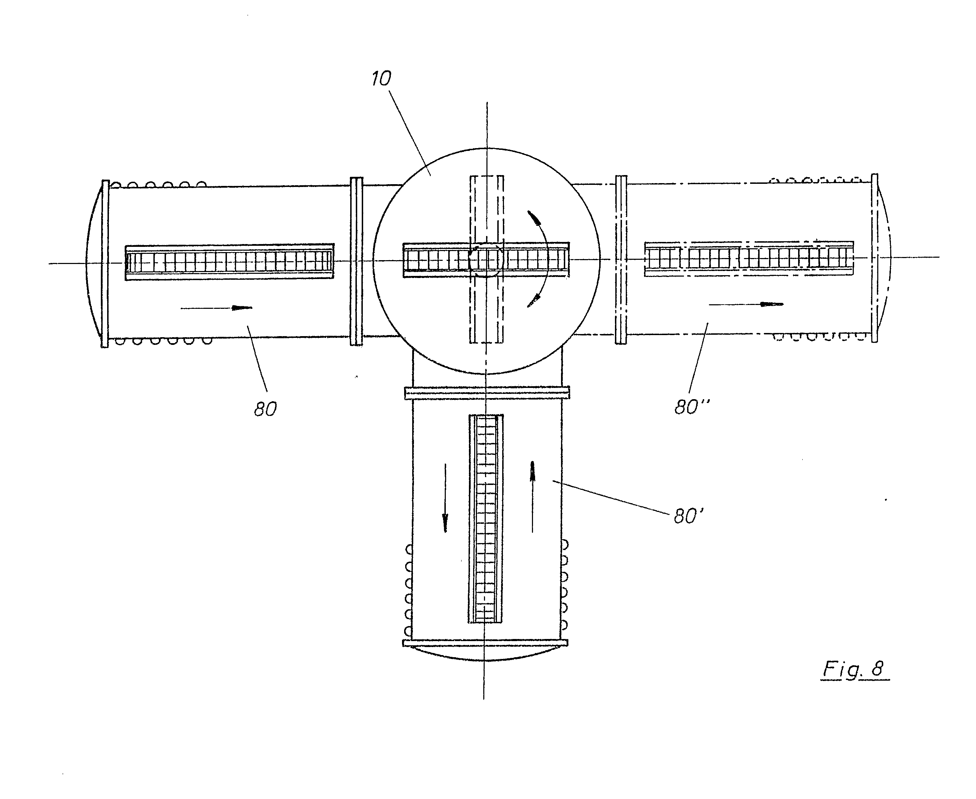

Fig. 1 zeigt ein erfindungsgemäßes Verbindungsstück im wesentlichen im Schnitt mit teilweise geschlossenem Absperrorgan, Fig. 1a zeigt einen Ausschnitt entsprechend einem Teil von Fig. 1 einer geänderten Ausführungsform, Fig. 1b zeigt die Dichtungsanordnung für das Verbindungsstück von Fig. 1, Fig. 2 zeigt einen Schnitt längs der Linie II-II von Fig. 1 bei geöffnetem Absperrorgan und einer modifizierten Ausführungsform, Fig. 3 zeigt ein Verbindungsstück mit einer Ausführungsform einer Transporteinrichtung im Schnitt, Fig. 4 zeigt eine Draufsicht von Fig. 3, Fig. 5 zeigt ein Verbindungsstück mit einer Hub- und Senkeinrichtung im Schnitt, Fig. 6 zeigt ein Verbindungsstück mit einer weiteren Zusatzeinrichtung, Fig. 7 zeigt eine weitere Transporteinrichtung für ein Verbindungsstück, Fig. 8 zeigt ein Verbindungsstück mit daran angeschlossenen Behältern von oben.

Das in Fig. 1 dargestellte Verbindungsstück 10 besitzt ein zylindrisches Gehäuse 11 mit gegenüberliegenden kreisförmigen Stirnwänden 11a und einem zylindrischen Teil 11b, wobei in dem Gehäuse 11 ein Absperrorgan 12 drehbar angeordnet ist. Das Absperrorgan 12 besteht aus zwei Lagerscheiben 13 benachbart den Stirnwänden 11a, die durch ein teilzylindrisches Absperrschild 14 miteinander verbunden sind, das sich über mindestens etwa ein Viertel des Umfangs des Teilzylinders erstreckt (gemäß Fig. 2 über ein Viertel dieses Umfangs).

Die Lagerscheiben 13 sind auf zwei Achsstummeln 15', 15" angeordnet, die sich durch die gegenüberliegenden Stirnwände 11a des Gehäuses 11 nach außen erstrecken, wobei ein Achsstummel 15' in einem außen am Gehäuse 11 angeordneten Lager 16 gelagert und der gegenüberliegende Achsstummel 15" mit einem Antrieb 17 zum Drehen des Absperrorgans 12 verbunden

ist. Der Antrieb 17 kann beispielsweise aus einem Elektromotor 18 und einem Getriebe 19 bestehen, es kann sich aber
auch um einen manuellen, pneumatischen oder hydraulischen
Antrieb handeln. Die Achsstummel 15', 15" können vakuumdicht
durch entsprechende Anordnung von (nicht dargestellten) Dichtungen eingebaut und mit dem Absperrorgan 12 beispielsweise
durch Schweißen verbunden sein.

Die Lagerscheiben 13 besitzen zweckmäßigerweise sich hierzu
senkrecht erstreckende Flansche 20 und können jeweils durch
beispielsweise drei Stege 21, die sich zwischen den Achsstummeln 15' bzw. 15" und den Flanschen 20 erstrecken, versteift
sein.

An dem zylindrischen Teil 11b des Gehäuses 11 sind bei dem
dargestellten Ausführungsbeispiel gegenüberliegend zwei Anschlußstücke 22 angeordnet, die jeweils aus einem Rohrstutzen
22a und einem Anschlußflansch 22b bestehen, während die gegenüberliegenden, durch die Anschlußstücke 22 gebildeten
Durchtrittsöffnungen des zylindrischen Teils 11b einen Durchmesser entsprechend dem Innendurchmesser der Rohrstutzen 22a
besitzen.

Zur Abdichtung des Absperrorgans 12 kann man benachbart zu
den Durchtrittsöffnungen des zylindrischen Teils 11b des Gehäuses 11 jeweils eine Ringnut zur Aufnahme einer Ringdichtung vorsehen. Da eine derartige Nut jedoch nicht in einer
ebenen Fläche anzubringen ist und die Dichtung stark beansprucht würde, wird es bevorzugt, in dem zylindrischen Teil
11b des Gehäuses 11 im Bereich der Flansche 20 jeweils mindestens eine Nut in Umfangsrichtung des zylindrischen Teils
11b anzuordnen, die zur Aufnahme von ringförmigen Radialdichtungen 23 dient. Hierdurch werden die Lagerscheiben 13
gegenüber dem Gehäuse 12 wirksam vakuumdicht abgedichtet,
ohne daß die Dichtungen Scherbeanspruchungen unterworfen werden. Zusätzlich ist dann noch das Absperrbild 14, wenn es
sich in einer Schließstellung befindet, abzudichten, zu
welchem Zweck parallel zur Achse des zylindrischen Teils 11b in diesem benachbart zu und beiseitig von dessen Durchtrittsöffnungen Längsnuten angebracht sind, die Liniendichtungen 24 aufnehmen, mit denen das Absperrschild 14 in Schließstellung in dichtendem Eingriff steht.

Die Dichtungsanordnung ist im einzelnen in Fig. 1b gezeigt, hierbei ist es wesentlich, daß die Liniendichtungen 24 mit den Radialdichtungen 23 derart zusammenwirken, daß an den Stoßstellen keine Undichtigkeiten auftreten. Zu diesem Zweck wird es bevorzugt, daß die Dichtungen 23,24 durch Vulkanisieren miteinander verbunden werden. Insbesondere werden im Bereich der Verbindungsstellen T-Stücke 23a eingesetzt, die an die Dichtungen 23,24 anvulkanisiert sind. Zwar zeigt die Fig. 1b nur schematisch Dichtungen mit quadratischem Querschnitt, letzter ist jedoch in der Praxis komplizierter, so werden Quadroringdichtungen oder dgl. verwendet, so daß im Bereich der T-Stücke 23a kontinuierliche Übergänge in den Konturen vom Quer- zum Längsschenkel vorgesehen sein müssen, um die erwünschte Abdichtung zu bewirken.

Im Bereich der Dichtungen 23, 24 sind zweckmäßigerweise Wasserkühlschlagen 25 an dem Gehäuse 11 vorgesehen, die durch eine Verbindungsschlange 26 untereinander verbunden sein können, wobei die Verbindungsschlangen 26 im Bereich der Liniendichtungen 24 verlaufen.

Einrichtungen zum Transportieren von zu behandelnden Werkstücken von einem Vakuumbehälter zum anderen können vorgesehen sein, indem beispielsweise wie dargestellt Transportschienen 27 in den Anschlußstücken 22 vorgesehen sind, während ebenfalls an der Innenseite des Absperrschildes 14 Transportschienen 28 angeordnet sind, die durch Drehung des Absperrschildes 14 in die geöffnete Stellung mit den Transportschienen 27 fluchten und eine Übergabe der Werkstücke von einem Vakuumbehälter zum Absperrschild 14 bzw. vom Absperrschild 14 zum anderem Vakuumbehälter ermöglichen.

Gemäß Fig. 1a können die Lagerscheiben 13 auch eine axiale Lagerbuchse 13' aufweisen, die auf Achsstummel 15', 15" angeordnet sind, wobei der nicht zum Drehen des Absperrorgans 12 verwendete Achsstummel 15' feststehend sein kann, während der andere Achsstummel 15" mit der entsprechenden Lagerbuchse 13' zwecks Drehung in Eingriff steht bzw. bei feststehendem Achsstummel 15" eine mit der Lagerbuchse 13' in Eingriff stehende antreibbare Welle in dem Achsstummel 15" vorgesehen ist.

Gemäß Fig. 2 können die Wasserkühlschlangen 26 insgesamt rund um das Gehäuse 11 herum im Bereich der Radialdichtungen 23 verlaufen, wenn letztere genügend nahe in Bezug auf die Stirnwände 11a angeordnet sind.

Das in den Figuren 1 und 2 dargestellte Verbindungsstück 10 eignet sich zum Verbinden von zwei Behältern in horizontaler linearer Richtung. Bei der in Fig. 2 dargestellten Stellung kann das zu behandelnde Gut von einem Behälter in das Verbindungsstück 10 über die Transportschienen 27, 28 eingeschoben werden. Hierauf kann das Absperrorgan 12 durch Verdrehen um 90$^{\circ}$ in seine geschlossene Stellung gebracht werden, wobei das zu behandelnde Gut über die Transportschienen 27 in den weiteren Behälter rollt.

Das in den Figuren 1 und 2 dargestellte Verbindungsstück 10 kann ferner insgesamt um 90$^{\circ}$ verdreht verwendet werden, wobei bei Verwendung von Transportschienen 28 diese auf der dann unten befindlichen (bei nicht hängendem Transport) Lagerscheibe 13 anzuordnen sind. Das Verbindungsstück kann aber auch L-förmig ausgebildet sein, d.h. daß die Durchtrittsöffnungen senkrecht zueinander angeordnet sind. Die hierbei auf der Lagerscheibe 13 anzuordnenden Transportschienen 28 bewirken, daß die Lagerscheibe 13 als Drehscheibe wirkt.

Wenn sich bei L-förmigem Verbindungsstück 10 das Absperrorgan 12 über einen Winkel von etwa 180$^{\circ}$ erstreckt, kann das Verbindungsstück 10 vollständig verschlossen werden. Hierbei wird bevorzugt das Verbindungsstück 10 selbst als Behandlungsbehälter auszubilden, so daß das zu behandelnde Gut beispielsweise in einem ersten Behälter auf Behandlungstemperatur aufgeheizt, in dem Verbindungsstück 10 eine Oberflächennitrierung durch Glimmentladungsbehandlung und in einem weiteren Behälter, der auf der gleichen Ebene oder unterhalb des Verbindungsstücks 10 sein kann, abgekühlt oder abgeschreckt wird. Das Abkühlen kann dabei in einem Behälter vorgenommen werden, der in der gleichen Ebene wie der Behälter zum Aufheizen und das Verbindungsstück 10 angeordnet ist, wobei die Abkühlung etwa durch Belüften oder Spülen mit Stickstoff erfolgt, während in dem Behälter zum Aufheizen und in dem Verbindungsstück 10 Vakuum aufrechterhalten wird. Nach Abkühlen und Ausbringen des behandelten Gutes wird der Abkühlbehälter evakuiert und kann wieder durch Öffnen des Absperrorgans 12 mit dem Verbindungsstück 10 zur Übernahme des darin befindlichen Gutes in Verbindung gebracht werden. Entsprechendes gilt für den Aufheizbehälter.

Beim Abschrecken befindet sich der entsprechende Behälter zweckmäßigerweise unter dem Verbindungsstück 10, so daß man das zu behandelnde Gut in das in diesem Behälter befindliche Abschreckbad fallenlassen kann. Die Verwendung einer entsprechenden Anzahl von Behältern und Verbindungsstücken 10, die gegebenenfalls auch als Behandlungsbehälter dienen, können verschiedenartige Behandlungseinrichtungen in Form von Durchlauflinien zusammengestellt werden.

Würde man ein Verbindungsstück 10 gemäß den Figuren 1 und 2 als Behandlungsbehälter verwenden, dann muß sich der Absperrschild 14 über etwa 270° erstrecken, damit beide Durchtrittsöffnungen gleichzeitig geschlossen werden können.

Entsprechendes gilt für ein T-förmiges Verbindungsstück 10 mit drei Durchtrittsöffnungen.

Bei L-förmigem Verbindungsstück muß sich zu diesem Zweck der Absperrschild 14 über etwa 180° erstrecken.

Gemäß Fig. 3 und 4 kann eine Transporteinrichtung in dem Verbindungsstück 10 vorgesehen sein, die beispielsweise aus einem oder mehreren Armen 30 besteht, die mit einer Welle 31 verbunden sind, die in einem Aufsatzstück 11c des Gehäuses 11 gelagert ist. Die Welle 31 wird beispielsweise über eine Kurbel 32, an der eine am Gehäuse 11 angelenkte Kolbenzylindereinheit 33 angelenkt ist, hin- und hergedreht. Die Arme 30 ergreifen bei der Drehung eine mit dem zu behandelnden Gut beladene Chargierplatte, die beispielsweise als Wagen ausgebildet sein kann, und schieben diese aus dem Verbindungsstück 10 in der einen und/oder der anderen Richtung heraus, während das Einschieben von den angeschlossenen Vakuumbehältern aus erfolgt.

Gemäß Fig. 5 ist eine Hub- und Senkeinrichtung in dem Verbindungsstück 10 vorgesehen, wobei ein L-förmiges Verbindungsstück 10 mit einer nach unten gerichteten Durchtrittsöffnung dargestellt ist. Die Hub-und Senkeinrichtung besteht aus einer Gabel 35, die an der Kolbenstange einer Kolbenzylindereinheit 36 befestigt ist, die auf dem Gehäuse 11 des Verbindungsstückes 10 montiert ist und vakuumdicht mit dem Inneren hiervon in Verbindung steht. Mit Hilfe der Gabel 35 kann eine Chargierplatte ergriffen und angehoben bzw. abgesenkt werden. Der Absperrschild 14 erstreckt sich bei der dargestellten Ausführungsform über ein Viertel des Umfangs und dient beispielsweise zum Verschließen des Zugangs zu einem Ölhärtebehälter unterhalb des Verbindungsstücks 10. Die Hub- und Senkeinrichtung kann auch mit um ihre Achse drehbarer Gabel 35 ausgebildet sein und ferner als Übergabeeinrichtung verwendet werden.

Gemäß Fig. 6 sind seitlich oder oben und unten an einem Verbindungsstück 10 etwa hydraulisch betätigbare Kolbenzylindereinheiten 40', 40" angeordnet, die zwischen sich das zu behandelnde Gut aufnehmen und halten können. Die Kolbenzylindereinheiten 40', 40" sind innerhalb einer Hohlwelle 41 angeordnet, die von außen mittels eines Motors 42 gedreht werden kann. Anstelle der Kolbenzylindereinheiten 40', 40"

0011160

können auch Spindeln oder dergleichen verwendet werden. Die Hohlwelle 41 wird durch ein Kegelrad und ein mit ihr kraftschlüssig verbundenes Tellerad angetrieben.

In Fig. 7 ist eine Transporteinrichtung dargestellt, die zum Transport einer Chargierplatte 50 für das zu behandelnde Gut in einem Verbindungsstück 10 und gegebenenfalls ebenso in den angeschlossenen Behältern dient, wobei die Chargierplatte 50 an ihrer Unterseite mit einer oder zwei Reihen von Zähnen 51 bzw. Zangstangen versehen ist.

Die Transporteinrichtung selbst weist Tragarme 52 auf, die an ihrem freien Ende ein Umlenkrad 53 besitzen und an einer Hohlwelle 54 befestigt sind. Die Hohlwelle 54 erstreckt sich durch das Gehäuse 11 des Verbindungsstücks 10 in dessen Inneres und nimmt ein Antriebsrad 55 für eine (gegebenenfalls zwei) Zahnkette 56 auf, deren Zähne mit den Zähnen 51 der Chargierplatte 54 in Eingriff bringbar sind, so daß die Chargierplatte 50 über die Zahnkette 56, das Antriebsrad 55 und eine dieses antreibenden Antriebswelle 57, die selbst von einem Motor 58, etwa einem Zahnradmotor, angetrieben wird, transportiert werden kann.

Die Zahnkette 56 ist mit den Zähnen 51 der Chargierplatte 50 in Eingriff bringbar, indem sie vertikal durch Kolbenzylindereinheiten 59, die hydraulisch betätigbar sein können, angehoben wird. Das untere Ende der Hohlwelle 54 ist durch Axiallager in Lagerschuhen an den freien Enden der Kolbenstangen der Kolbenzylindereinheiten und am Gehäuse 11 durch Axiallager gelagert. Die Transporteinrichtung kann auch um die Achse der Hohlwelle 54 mittels eines geeigneten Antriebs gedreht werden.

Bei der Behandlung von Werkstücken durch Gasentladungen, etwa zum Plasmanitrieren, ist es notwendig, die Werkstücke gegenüber dem Behälter zu isolieren und an die Kathode einer Stromquelle anzuschließen, während der Behälter oder eine zusätzliche Elektrode anodisch geschaltet werden (bei Mehrphasenstrom gilt dies nur zeitweise). Dadurch, daß die Transporteinrichtung außer Eingriff mit der Chargierplatte gebracht werden kann, die dann auf Schienen lagert, ist es möglich, in dem Verbindungsstück 10 eine Behandlung der Werkstücke mittels Glimmentladungen vorzunehmen, indem die Werkstücke mit einer Stromquelle verbunden werden, während die Schienen isoliert gegenüber dem Gehäuse angeordnet werden, wobei letzteres mit dem anderen Pol der Stromquelle verbunden wird. Die Stromzuführung zu der Chargierplatte kann durch die Hohlwelle 54 ebenso wie der Anschluß für eine Vakuumpumpe erfolgen.

Gemäß Fig. 8 ist ein T-förmiges Verbindungsstück 10 vorgesehen, in dem eine Transporteinrichtung nach Fig. 7 vorhanden ist. Letztere ist drehbar, so daß das Gut entsprechend in einen der angeschlossenen Behälter 80, 80', 80" oder bei nicht vorhandenem Behälter 80" ins Freie transportiert werden kann. Die Behälter 80, 80', 80" sind ebenfalls mit der in Fig. 7 dargestellten Transporteinrichtung versehen, um eine Übergabe des Gutes auf die Transporteinrichtung des Verbindungsstücks zu ermöglichen.

Patentansprüche:

1. Verbindungsstück für Vakuumbehälter zum Wärmebehandeln von Werkstücken, wobei insbesondere mindestens ein Vakuumbehälter zum Behandeln von Werkstücken mit Hilfe von Gasentladungen geeignet ist, mit einem mit Durchtrittsöffnungen versehenen Gehäuse, in dem ein in vakuumdichter Schließstellung bewegliches Absperrorgan angeordnet ist, und Anschlußstücken zum Anschließen von Behältern, dadurch gekennzeichnet, daß das Verbindungsstück (10) aus einem zylinderförmigen Gehäuse (11) und einem darin befindlichen, sich gegenüber diesem drehbaren Absperrorgan (12) besteht, wobei das Absperrorgan (12) aus einem teilzylinderischen Absperrschild (14) besteht, das sich über mindestens etwa ein Viertel des Zylinderumfanges des Gehäuses (11) erstreckt.

2. Verbindungsstück nach Anspruch 1,
dadurch gekennzeichnet,
daß das Absperrorgan (12) zwei Lagerscheiben (13) benachbart den Stirnwänden (11a) des zylinderförmigen Gehäuses (11) umfaßt, die durch den Absperrschild (14) miteinander verbunden sind.

3. Verbindungsstück nach Anspruch 1 oder 2,
dadurch gekennzeichnet,
daß das Absperrorgan (12) beidseitig der Durchtrittsöffnungen Ringflansche (20) benachbart den Stirnwänden (11a) des zylinderförmigen Gehäuses (11) aufweist, die sich in Axialrichtung des Gehäuses (11) erstrecken.

4. Verbindungsstück nach Anspruch 3,
dadurch gekennzeichnet,
daß die Lagerscheiben (13) durch sternförmig angeordnete Stege (21) verstärkt sind.

5. Verbindungsstück nach einem der Ansprüche 1 bis 4,
dadurch gekennzeichnet,

0011160

daß an einer zu verschließenden Durchtrittsöffnung beidseitig in Drehrichtung des Absperrorgans (12) jeweils eine sich in Richtung der Längsachse des zylinderförmigen Gehäuses (11) erstreckende Liniendichtung (24) und ebenfalls beidseitig der Durchtrittsöffnung in Radialrichtung des Gehäuses (11) jeweils eine Radialdichtung (23) für das Absperrorgan (12) vorgesehen ist.

6. Verbindungsstück nach einem der Ansprüche 1 bis 5, dadurch gekennzeichnet, daß das zylinderförmige Gehäuse (11) im Bereich der Dichtungen (23,24) wassergekühlt ist.

7. Verbindungsstück nach einem der Ansprüche 1 bis 6, dadurch gekennzeichnet, daß das Absperrorgan (12) Transportschienen (27) aufweist, die sich in den Anschlußstücken (22) fortsetzen.

8. Verbindungsstück nach einem der Ansprüche 1 bis 7, dadurch gekennzeichnet, daß in dem Verbindungsstück (10) eine Transporteinrichtung, insbesondere ein Kettenförderer mit ein oder zwei Zahnketten (56) vorgesehen ist.

9. Verbindungsstück nach einem der Ansprüche 1 bis 8, dadurch gekennzeichnet, daß das zu behandelnde Gut in dem Verbindungsstück (10) insbesondere durch die Transporteinrichtung drehbar und/oder anhebbar ist.

10. Verbindungsstück nach Anspruch 8, dadurch gekennzeichnet, daß der Kettenförderer durch eine Hohlwelle (54) hindurch antreibbar ist, die von außerhalb des Verbindungsstückes (10) heb- und senkbar ist, wodurch der Kettenförderer insgesamt heb- und senkbar ist.

0011160

Fig.1

Fig.1a

Fig.1b

24

230

23

2/8

0011160

0011160

Fig.2

Fig.4

Fig.3

Fig.5

36

35

10

28

17

22

27

Fig.6

40″

41

21    41

40′

42

Fig.7

10

80

80'

80''

*Fig. 8*

0011160

Nummer der Anmeldung

Europäischer
Patentamt

EUROPÄISCHER RECHERCHENBERICHT

EP 79 104 118.9

| Kategorie | Kennzeichnung des Dokuments mit Angabe, soweit erforderlich, der maßgeblichen Teile | betrifft Anspruch |
|---|---|---|
| A | DE - U - 1 786 430 (SIEMENS SCHUCKERT-WERKE) | |
| | -- | |
| A | DE - B2 - 2 246 886 (C.I. HAYES) | |
| | -- | |
| A | DE - A - 1 808 857 (C.I. HAYES) | |
| | -- | |
| A | DE - A - 2 232 426 (M.F.W. KNOWLES) | |
| | -- | |
| | DE - A1 - 2 657 077 (KAWASAKI JUKOGYO) | |
| | -- | |
| A | US - A - 3 212 765 (IPSEN INDUSTRIES) | |
| | -- | |
| A | US - A - 4 118 016 (C.I. HAYES) | |
| | ---- | |

### KLASSIFIKATION DER ANMELDUNG (Int.Cl.3)

C 21 D    1/773
C 21 D    1/38
C 23 C    11/14
F 27 E    9/04

### RECHERCHIERTE SACHGEBIETE (Int.Cl.3)

B 01 J    3/02
C 21 D    1/38
C 21 D    1/74
C 21 D    1/773
C 23 C    11/14
F 16 K    51/02
F 27 E    9/04

### KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt

| Recherchenort Berlin | Abschlußdatum der Recherche 27-02-1980 | Prüfer SUTOR |
|---|---|---|